# EUROPEAN PATENT APPLICATION

(11) **EP 2 139 025 A1**
(43) Date of publication of application: **30.12.2009**
(21) Application number: 08011461.4
(22) Date of filing: 25.06.2008
(51) Int. Cl.: H01L 21/00, H01L 31/18

(54) **Arrangement for coating a cristalline silicon solar cell with an antireflection/passivation layer**

(71) Applicant: Applied Materials, Inc., Santa Clara, CA 95054 (US)
(72) Inventor: Liu, Jian, 63538 Grosskrotzenburg (DE)
(74) Representative: Schickedanz, Willi

(57) **Abstract**

In the plasma pretreatment a substrate, preferably a silicon solar cell, is transported into a pretreatment chamber (1). In this pretreatment chamber (1) is contained a gas mixture comprising at least NH₃ or hydrogen. By means of a cathode (4) a plasma is generated in the pretreatment chamber (1) by means of a glow discharge. The atomic hydrogen in the plasma reacts hereby with the oxygen, which is located on the solar cell (25) in the form of an oxide layer By modifying or removing the oxide layer, better passivation of the solar cell can be attained and, consequently, higher efficiency.

## Description

The invention relates to an arrangement according to the preamble of patent claim 1.

A method for the production of a photovoltaic solar cell is already known, in which in a pretreatment of the substrate an ammonia plasma treatment and a silane/ammonia reaction plasma treatment are successively applied (DE 37 90 981 B4). The ammonia plasma treatment serves for implanting hydrogen into a surface while the silane/ammonia reaction plasma treatment serves for developing a polysilazane coating on this surface.

Furthermore is known a doubly coated composite steel object containing a nitrided layer formed through the action of a glow discharge on the surface of the metal part using gaseous ammonia and gaseous hydrogen (DE 195 26 387 A1).

Further known is an arrangement for the plasma treatment of a substrate and a method for operating the arrangement, wherein two linear electrodes are provided located on one side of the substrate (DE 10 2004 043 967 A1) A plasma source housing shields the side of the electrodes facing away from the substrate and is open toward the substrates.

In the case of duplex coated steel components it is known to apply a first layer of nitride by means of a glow discharge while ammonia and hydrogen are being supplied (US 6 117 280). A second hardening layer of nitride, carbide or carbonitride is hereupon applied onto the steel components.

Further is known a method for the production of passivated antireflective layers for photovoltaic cells, in which the surface of a semiconductor substrate is oxidized and subsequently several regions of p- and n-conducting type are doped (US 5 011 782). First and second metallization layers are subsequently formed, which connect the doped regions. Hereupon silicon nitride is applied onto the metal layer as a protective etching layer. The substrate is subsequently thinned by etching a second larger surface which is opposite a first larger surface. Lastly, an antireflective material is applied on the second larger surface.

A method for the production of solar cells is also known, in which the cells receive a silicon nitride coating in a vacuum chamber and are subjected to ammonia plasma hydrogenation (US 6 091 021).

A method is, lastly, also known with which photocells of silicon are simultaneously passivated in a vacuum chamber and provided with an anti-reflecting layer (DE 10 2006 035 563 A1). Herein in the vacuum chamber an electromagnetic energy source is disposed which generates ions. The coating of the photocells takes place by means of a CVD method

The invention addresses the problem of passivating solar cells that are coated with the aid of sputter installations.

This problem is solved according to the characteristics of patent claim 1.

The advantage attained with the invention resides in particular therein that an expensive TwinMag plasma pretreatment during or before the sputtering can be omitted and a more cost-effective pretreatment is carried out by means of glow discharge.

To increase the efficiency of wafer-based solar cells, with this arrangement onto the front side of the solar cell an antireflection layer, as a rule SiN, is applied. The recombination centers in the wafer material, primarily in multicrystalline solar cells the so-called "dangling bonds", are passivated in order to minimize the recombination of the charge carriers in the material. For the passivation serves hydrogen that is introduced into the silicon nitride. A SiN:H layer is formed in the process. In a subsequent high-temperature process (contact firing) the hydrogen diffuses into the wafer material where the hydrogen atoms saturate the "dangling bonds" and thus passivate the wafer. In the coating process the hydrogen, for example in the form of ammonia, can be introduced as the process gas.

In order to obtain as optimal a diffusion of the hydrogen as is possible, it is of advantage to pretreat the wafer surface before the deposition of the SiN:H layer. Through their passivation the electrical properties of the solar cells are improved.

In the plasma pretreatment a substrate, preferably a silicon solar cell, is transported into a pretreatment chamber. In this pretreatment chamber is a gas mixture which contains at least ammonia (NH₃) or hydrogen (H₂). By means of a cathode in the pretreatment chamber a plasma is generated by means of glow discharge. Thereby the hydrogen in the plasma reacts with the oxygen which is disposed in the form of an oxide layer on the solar cell. By removing the oxide layer, passivation of the solar cell can be achieved and, consequently, a high efficiency can be attained.

An embodiment example of the invention is depicted in the drawing and will be described in the following in further detail. In the drawing depict:
Fig. 1 a schematic depiction of a pretreatment chamber,
Fig. 2 the pretreatment chamber according to Fig. 1 as part of a coating installation,
Fig. 3 an inline installation.

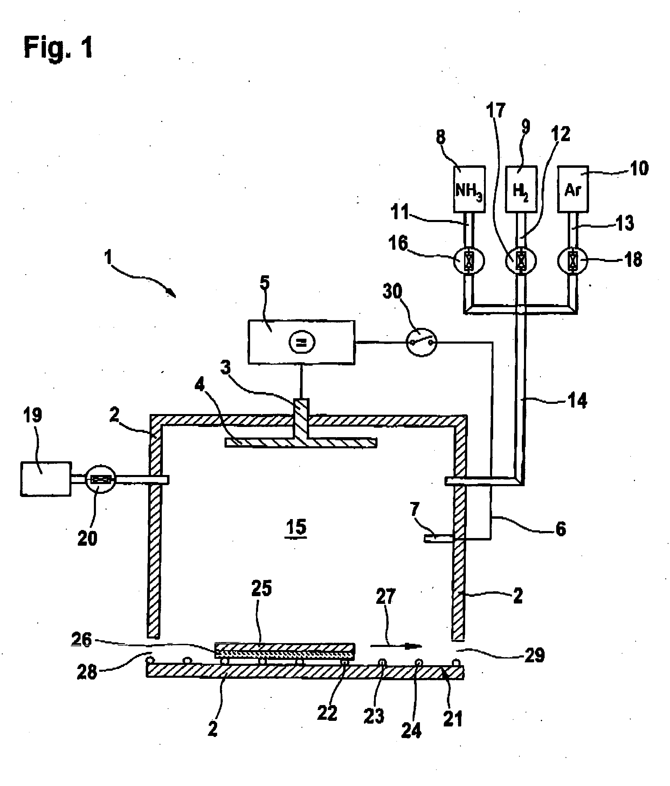

Figure 1 shows a pretreatment chamber 1 for crystalline solar cells. Evident is a wall 2 of the forevacuum chamber 1 as well as a plate 4 disposed on a carrier 3. This plate 4 is a metal plate suspended in the pretreatment chamber 1. This metal plate 4 is connected via the carrier 3 to a DC voltage source 5. The DC voltage source 5 is further connected via an electric line 6 to an anode 7. The metal plate 4 thus functions as a cathode 4. Evident are further three gas tanks 8,9,10, which are connected via lines 11,12,13 with a main line 14. This main line 14 leads into the interior 15 of the pretreatment chamber 1. Between the main line 14 and each of the lines 11,12,13 a valve 16, 17, 18 is disposed. The interior 15 of the pretreatment chamber 1 can thus be charged via line 14 with at least one of the gases located in the gas tanks 8 to 10. In gas tank 8 is contained ammonia (NH₃), in gas tank 9 hydrogen (H₂) and in gas tank 10 a further gas, for example argon (Ar). On the pretreatment chamber 1 is further disposed a vacuum pump 19. Between the vacuum pump 19 and the pretreatment chamber 1 is located a valve 20. Opposite the metal plate 4 a transport system 21 is evident, which is comprised of several rollers 22 - 24. By means of this transport system 21 a substrate 25, preferably a solar cell, can be transported through the interior 15 of the pretreatment chamber 1. For this purpose, as is evident in Figure 1, the substrate 25 is disposed on a carrier 26 such that the carrier 26 with the substrate 25 can be moved on the transport system 21 in the direction of an arrow 27.
Consequently, the substrate 25 reaches through an opening 28 the interior 15 of the pretreatment chamber 1 and is again moved out of the pretreatment chamber 1 through a further opening 29.

The pretreatment of the substrate 15 is carried out in the following manner.

The pretreatment chamber 1 is first brought to 10⁻² to 10⁻³ mbar with the aid of the vacuum pump 19. Into the interior 15 of the pretreatment chamber 1 NH₃ is subsequently introduced from the gas tank 8. To improve plasma formation, in addition, for example argon can be let into the pretreatment chamber 1. The quantity of gas which is to be introduced into the pretreatment chamber 1 can be adjusted via the valves 16 or 18. To make the pretreatment even more effective, H₂ can additionally be introduced from gas tank 9 into the interior 15 of the pretreatment chamber 1.

After at least ammonia has been introduced into the interior 15 of the pretreatment chamber 1, via a switch 30 DC current is applied to the plate 4. Since the DC voltage source 5 is preferably a high-voltage source, preferably DC high-voltage is consequently applied to the plate. Through this DC voltage a plasma is generated via a glow discharge. This plasma can subsequently act onto the substrate 25 introduced into the pretreatment chamber 1. Although in Figure 1 only one substrate is located, it is obvious that on the carrier 26 several substrates can also be disposed. However, this is not shown in Figure 1. This plasma now reacts with the surface of substrate 25. Since the substrate 25, before it was introduced into the pretreatment chamber 1, had been subjected to a wet-chemical etching process, an oxide layer has formed on the substrate 25. In this wet-chemical etching process the substrate was placed into a bath of hydrofluoric acid. After this etching process the substrate was rinsed with water and dried. After the drying the substrate was subsequently transported in the direction toward the coating chamber. Since during the transport the substrate is exposed to the atmosphere, an oxide, a so-called native oxide, has formed on the surface of the substrate. Since this oxide prevents the substrate from being adequately passivated, this oxide must be modified or eroded. The removal of the oxide thus takes place before the coating proper of the substrate. The hydrogen-containing gas in the plasma in the pretreatment chamber 1 thus removes the oxide layer. Therewith is attained that the hydrogen, introduced during the coating into the SiN layer, can diffuse into the wafer in the subsequent firing process. This coating takes place in a coating chamber adjoining the pretreatment chamber 1, however not shown in Figure 1. In this coating chamber the substrate 25 is coated by means of a sputter process. As gases are employed argon, NH₃ and nitrogen (N₂). In the coating an SiN:H layer is formed. After this coating the substrate is subjected to a firing process in which hydrogen diffuses into the substrate and thus passivates the wafer material. However, since the oxide layer would prevent hydrogen from being able to diffuse in sufficient quantity into the substrate, it is important to modify or to remove this oxygen layer. If the oxygen layer were not removed, hydrogen could not diffuse into the substrate but rather would continue to remain in the SiN:H layer. During the firing process on the surface of the layer small bubbles would form which burst. This effect is referred to in general as blistering. However, the more bubbles formed on the surface of the substrate, i.e. on the surface of the solar cell, the lower is the efficiency of the solar cell. For that reason it is important to reduce the bubble formation, which is ensured by removing the oxide layer. The pretreatment, consequently, has a direct effect on the efficiency of solar cells.

It is understood that in principle it is also feasible to carry out the pretreatment in a pretreatment chamber with two adjacent sputter cathodes (Twin-Mags). However, since the sputter cathodes would have to be supplied with current from an AC voltage source, such a process is, of course, far more expensive than the process described here, in which in the pretreatment chamber only one metal plate is located as the cathode. Of disadvantage in the pretreatment with two AC current-supplied sputter cathodes is further that the sputter cathodes must be operated with low power in order for a sputter process to be suppressed.

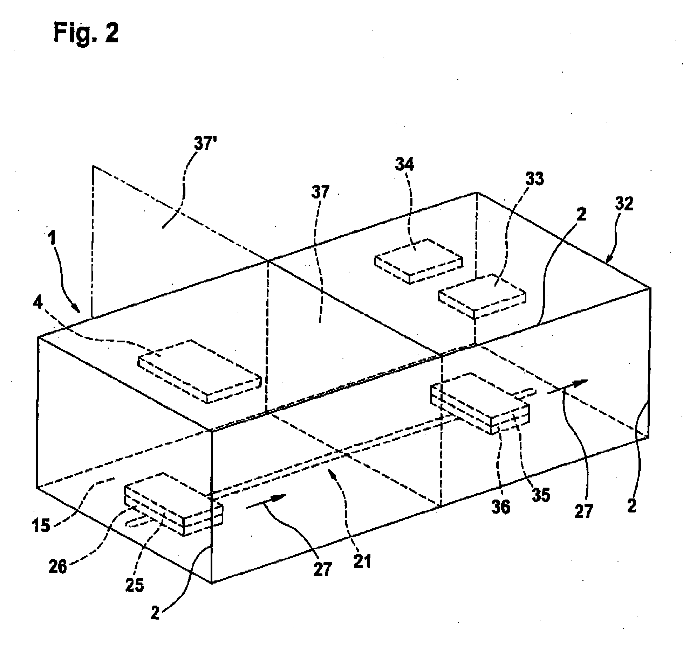

Figure 2 shows again the pretreatment chamber 1 as part of a coating installation 31, however in perspective view. Evident is the transport arrangement 21, which, however, is only shown schematically. This transport arrangement can be either a roller system, such as depicted in Figure 1, or a rail system, on which the substrate 25 disposed on the carrier 26 can be moved in the direction of arrow 27. Above the transport system 21 is disposed the metal plate 4 which is connected to the DC current source not shown here. The transport of the substrate 25 disposed on the carrier 26 takes place by means of a driving system not depicted here. The gas supplies and the vacuum pump are not shown in Figure 2 for the sake of clarity. Adjoining the pretreatment chamber 1 can be seen a coating chamber 32, in which two targets 33, 34 (TwinMag targets) are disposed. Beneath these targets 33, 34 is located a further substrate 35, which is also disposed on a carrier 36 and is moved in the direction of arrow 27. The coating chamber 32 also comprises gas and voltage supplies which, however, are not depicted. The pretreatment chamber 1 and the coating chamber 32 are separated from one another by a lock wall 37, 37' which can be drawn out. Targets 33, 34 are each a part of a magnetron cathode which are operated with AC voltages in the range from 10 to 100 KHz, conventionally at 30 to 50 KHz, such that during one halfwave the magnetron is connected as the cathode and the other as the anode. In the subsequent halfwave the conditions are reversed such that during the coating each electrode is briefly the cathode or the anode Silicon is preferably utilized as the target material. As the gas, a mixture of argon as well as nitrogen is introduced into the coating chamber 32. In the sputter process argon knocks silicon particles out of the target such that these silicon particles react with the nitrogen and are deposited on the silicon solar cell 35 in order to form here an antireflective layer. Into the chamber, in addition, is preferably also supplied NH₃. Atomic hydrogen is therein formed in the coating chamber 32, which is incorporated in the SiN layer which forms on the surface of the silicon solar cell 35. Thus an SiN:H layer is formed. This SiN:H layer consequently forms the proper antireflective layer.

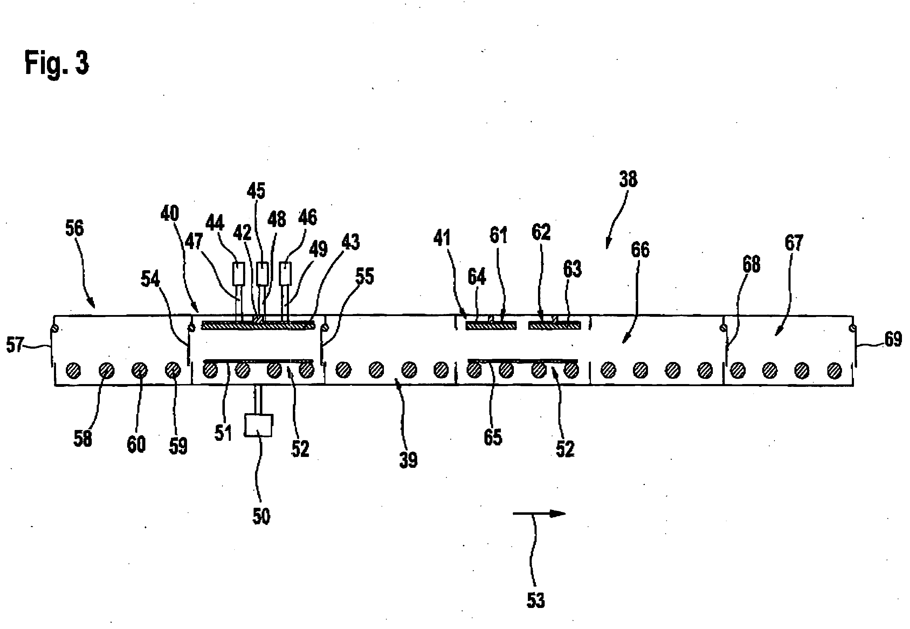

Figure 3 depicts a schematically shown inline installation 38, which includes a lock chamber 39 disposed between a pretreatment chamber 40 as well as a coating chamber 41. In the pretreatment chamber 40 is provided a metal plate 43 disposed on a carrier 42. Seen are further three gas tanks 44, 45, 46 connected via lines 47, 48, 49 with the pretreatment chamber 40. In the gas tank 44 is contained NH₃, in the gas tank 45 Ar and in the gas tank 46 H₂. As already explained in connection with Figure 1, the metal plate 43 is the cathode. For the sake of clarity, however, the anode is not shown in Figure 3. On the pretreatment chamber 40 is further disposed a vacuum pump 50 with which the pretreatment chamber can be evacuated when needed. In the pretreatment chamber 40 is further located a substrate 51, which is disposed on a carrier, not shown here, and can be moved on a transport system 52 in the direction of arrow 53. The pretreatment chamber 40 has further two gates 54, 55 serving as lock gates. The lock gate 54 separates the pretreatment chamber 40 from a lock chamber 56. This lock chamber 56 includes a further lock gate 57 separating the lock chamber 56 from the surrounding. The lock chamber 56 serves thus as the first chamber of the inline installation 38 into which a substrate is transported. Evident is again the transport system 52, which, as shown in Figure 3, is comprised of rollers 58, 59, 60 on which a substrate can be moved in the direction of arrow 53. Adjoining the lock chamber 39 is the coating chamber 41, This coating chamber 41 comprises two adjacent magnetron cathodes 61, 62 (Twin-Mag). Each of these two magnetron cathodes includes a target which is preferably comprised of silicon, These targets are denoted by the reference numbers 63, 64. In the coating chamber 41 is also disposed a substrate 65, a silicon wafer, that is moved on the transport system 52 in the direction of arrow 53. This substrate 65 is also disposed on a carrier which, however, is not shown in Figure 3. It is obvious to a person of skill in the art that, instead of one substrate, several substrates can also be guided simultaneously through a chamber, these substrates in this case being disposed jointly on a carrier. The coating chamber 41 is succeeded by a transfer chamber 66 which is adjoined by a further lock chamber 67. This lock chamber 67 is provided with an input gate 68 and an output gate 69. Between the lock chamber 56 and the pretreatment chamber 40 a further transfer chamber can still be disposed which, however, is not shown in Figure 3. Similarly, adjoining the lock chamber 39 a further transfer chamber can be located. This, however, is also not shown in Figure 3.

## Claims

1. Arrangement for coating a crystalline silicon solar cell with an antireflection/passivation layer, **characterized by**
1.1 a first chamber (1, 40) in which
1.1.1 a silicon solar cell (25, 35, 51, 65) is located,
1.1.2 an electric DC voltage can be applied for generating a glow discharge gap,
1.1.3 at least one gas supply (14, 47 - 49) is provided, which introduces at least ammonia or hydrogen into the chamber (1, 40),
1.2 a second chamber (32,41) in which a sputter device (33. 34, 63, 64) for the coating of the silicon solar cell is provided,
1.3 a transport means (21, 52) for the transport of the silicon solar cell (25, 35, 51, 65) from the first chamber (1.40) into the second chamber (32, 41).

2. Arrangement as claimed in claim 1, **characterized in that** the silicon solar cell (25, 35, 51, 65) is disposed on a carrier (26, 36).

3. Arrangement as claimed in claim 1, **characterized in that** between the first chamber (1, 40) and the second chamber (32, 41) a movable lock gate (37, 37') is disposed.

4. Arrangement as claimed in claim 1, **characterized In that** between the first chamber (1, 40) and the second chamber (32, 41) a lock chamber (39) is disposed.

5. Arrangement as claimed in claim 1, **characterized in that** in the first chamber (1, 40) a cathode (4, 43) is disposed, which is connected to a DC voltage source (5).

6. Arrangement as claimed in claim 5, **characterized in that** the DC voltage source (5) is connected to an anode (7) which is located in the first chamber (1, 40).

7. Arrangement as claimed in claim 1, **characterized in that** a vacuum pump (19, 50) is provided, which is connected with the first chamber (1,40) via a line.

8. Arrangement as claimed in claim 1, **characterized in that** the transport means (21, 52) is a system of rollers (22 - 24, 58 - 60).

9. Arrangement as claimed in claim 1, **characterized in that** the transport means (21, 50) is a rail system.

10. Arrangement as claimed in claim 1, **characterized in that** the gas supply (14, 47 - 49) is connected with at least one gas tank (8-10, 44 - 46).

11. Arrangement as claimed in claim 1, **characterized in that** in the at least one gas tank NH₃ or hydrogen is provided.

12. Arrangement as claimed in claim 10, **characterized in that** three gas tanks (8 - 10, 44-46) are provided, the first gas tank containing NH₃, the second gas tank H₂ and the third gas tank Ar,
